# EUROPEAN PATENT APPLICATION

(11) **EP 1 901 540 A1**
(43) Date of publication of application: **19.03.2008**
(21) Application number: 06019190.5
(22) Date of filing: 13.09.2006
(51) Int. Cl.: H04M 11/06

(54) **ADSL splitter**

(71) Applicant: YCL ELECTRONICS CO., LTD., Feng Shan City, Kaohsiung County (TW)
(72) Inventor: Chen, Yung-Sheng, Feng Shan City, Kaohsiung County (TW); Liu, Wen-Chung, Kaohsiung County (TW)
(74) Representative: GROSSE BOCKHORNI SCHUMACHER

(57) **Abstract**

A signal splitter includes a common mode choke circuit (34, 34') that includes a first choke coil (T1) having two input nodes (e) coupled to an incoming telephone line, and two output nodes (f) coupled respectively to two first input nodes (a) of a first filter inductor (L1) of a first filter circuit (31), and a second choke coil (T2) having two input nodes (g) coupled respectively to two second output nodes (d) of a second filter inductor (L2) of a third filter circuit (33), and two output nodes (h) coupled to a telephony instrument. A second filter circuit (32) includes a first capacitor (C1) coupled between two first output nodes (b) of the first filter inductor (L1) that are coupled respectively to two second input nodes (c) of the second filter inductor (L2). The third filter circuit (33) further includes a second capacitor (C2) coupled between the second output nodes (d) of the second filter inductor (L2).

## Description

The invention relates to a signal splitter, more particularly to a signal splitter capable of effectively suppressing common mode noise from an incoming signal in an incoming telephone line.

In an ADSL (Asymmetric Digital Subscriber Line) system, telephony and data signals can be transferred at the same time on a common telephone line.

In the traditional ADSL technology, a conventional signal splitter is coupled among an incoming telephone line, a telephony instrument, such as a telephone set, and a networking interface unit, such as an ADSL modem. The conventional signal splitter includes a low-pass filter for permitting a voice signal, i.e., a low-frequency component having a frequency ranging from 0 to 4 KHz, of an incoming signal in the incoming telephone line to pass therethrough to the telephony instrument. However, common mode noise from the incoming signal in the incoming telephone line cannot be effectively suppressed, thereby resulting in unstable impedance matching characteristics.

Therefore, the object of the present invention is to provide a signal splitter that can overcome the aforesaid drawbacks of the prior art.

According to the present invention, a signal splitter comprises:
a first filter circuit including a first filter inductor that has a pair of first input nodes adapted to be coupled to an incoming telephone line, and a pair of first output nodes;
a second filter circuit including a first capacitor coupled between the first output nodes of the first filter inductor;
a third filter circuit including
   a second filter inductor that has a pair of second input nodes coupled respectively to the first output nodes of the first filter inductor, and a pair of second output nodes, and
   a second capacitor coupled between the second output nodes of the second filter inductor; and
a common mode choke circuit including
   a first choke coil having a pair of input nodes adapted to be coupled to the incoming telephone line, and a pair of output nodes coupled respectively to the first input nodes of the first filter inductor, thereby permitting coupling of the first input nodes of the first filter inductor to the incoming telephone line, and
   a second choke coil having a pair of input nodes coupled respectively to the second output nodes of the second filter inductor, and a pair of output nodes adapted to be coupled to a telephony instrument.

Other features and advantages of the present invention will become apparent in the following detailed description of the preferred embodiments with reference to the accompanying drawings, of which:
Figure 1 is a schematic electrical circuit diagram illustrating the first preferred embodiment of a signal splitter according to the present invention; and
Figure 2 is a schematic electrical circuit diagram illustrating the second preferred embodiment of a signal splitter according to the present invention.

Before the present invention is described in greater detail, it should be noted that like elements are denoted by the same reference numerals throughout the disclosure.

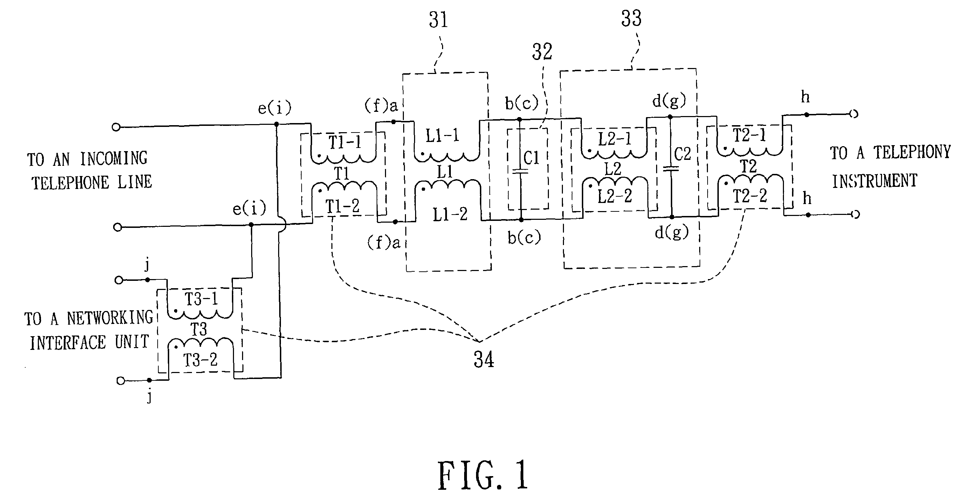

Referring to Figure 1, the first preferred embodiment of a signal splitter according to the present invention is shown to include a first filter circuit 31, a second filter circuit 32, a third filter circuit 33, and a common mode choke circuit 34.

The first filter circuit 31 includes a first filter inductor (L1) that has a pair of first input nodes (a) adapted to be coupled to an incoming telephone line, and a pair of first output nodes (b). In this embodiment, the first filter inductor (L1) includes a common core (not shown), and two mutually inductive windings (L1-1, L1-2) wound on the common core.

The second filter circuit 32 includes a first capacitor (C1) coupled between the first output nodes (b) of the first filter inductor (L1).

The third filter circuit 33 includes a second filter inductor (L2) and a second capacitor (C2). The second filter inductor (L2) has a pair of second input nodes
(c) coupled respectively to the first output nodes (b) of the first filter inductor (L1), and a pair of second output nodes (d). In this embodiment, the second filter inductor (L2) includes a common core (not shown), and two mutually inductive windings (L2-1, L2-2) wound on the common core. The second capacitor (C2) is coupled between the second output nodes (d) of the second filter inductor (L2).
   In this embodiment, the common mode choke circuit 34 includes first to third choke coils (T1, T2, T3). The first choke coil (T1) has a pair of input nodes (e) adapted to be coupled to the incoming telephone line, and a pair of output nodes (f) coupled respectively to the first input nodes (a) of the first filter inductor (L1), thereby permitting coupling of the first input nodes (a) of the first filter inductor (L1) to the incoming telephone line. The first choke coil (T1) includes a common core (not shown), and two mutually inductive windings (T1-1, T1-2) wound on the common core. The second choke coil (T2) has a pair of input nodes (g) coupled respectively to the second output nodes (d) of the second filter inductor (L2), and a pair of output nodes (h) adapted to be coupled to a telephone instrument, such as a telephone set. The second choke coil (T2) includes a common core (not shown), and two mutually inductive windings (T2-1, T2-2) wound on the common core. The third choke coil (T3) has a pair of input nodes (i) adapted to be coupled to the incoming telephone line, and a pair of output nodes (j) adapted to be coupled to a networking interface unit, such as an ADSL modem. The third choke coil (T3) includes a common core (not shown), and two mutually inductive windings (T3-1, T3-2) wound on the common core.

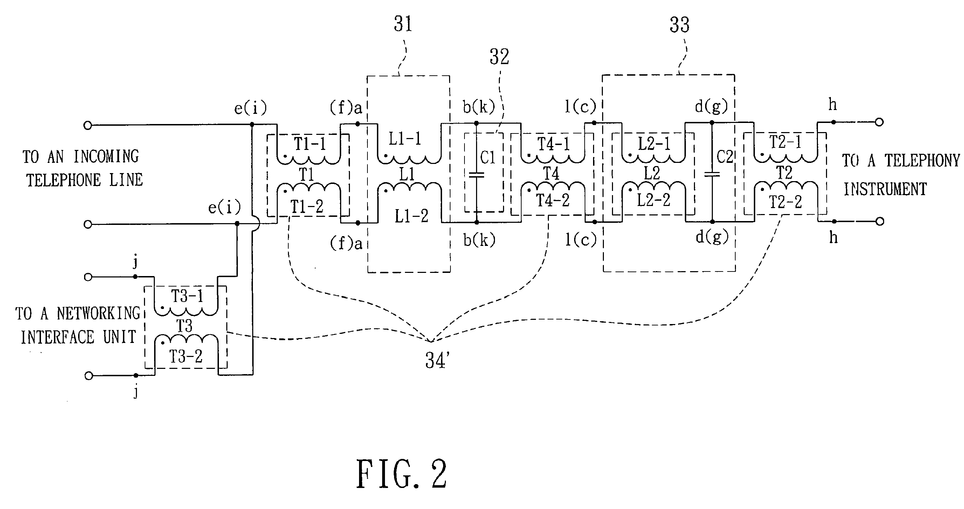

   Figure 2 illustrates the second preferred embodiment of a signal splitter according to this invention, which is a modification of the first preferred embodiment. Unlike the previous embodiment, the common mode choke circuit 34' further includes a fourth choke coil (T4) that has a pair of input nodes (k) coupled respectively to the first output nodes (b) of the first filter inductor (L1), and a pair of output nodes (1) coupled respectively to the second input nodes (c) of the second filter inductor (L2) such that the second input nodes (c) of the second filter inductor (L2) are coupled to the first output nodes (b) of the first filter inductor (L1) via the fourth choke coil (T4). In this embodiment, the fourth choke coil (T4) includes a common core (not shown), and two mutually inductive windings (T4-1, T4-2) wound on the common core.
   In sum, due to the presence of the common mode choke circuit 34, 34' , the common mode noise from the incoming signal in the incoming telephone line can be effectively suppressed, thereby resulting in stable impedance matching characteristics.

## Claims

1. A signal splitter, **characterized by**:
a first filter circuit (31) including a first filter inductor (L1) that has a pair of first input nodes (a) adapted to be coupled to an incoming telephone line, and a pair of first output nodes (b);
a second filter circuit (32) including a first capacitor (C1) coupled between said first output nodes (b) of said first filter inductor (L1);
a third filter circuit (33) including
a second filter inductor (L2) that has a pair of second input nodes (c) coupled respectively to said first output nodes (b) of said first filter inductor (L1), and a pair of second output nodes (d), and
a second capacitor (C2) coupled between said second output nodes (d) of said second filter inductor (L2); and
a common mode choke circuit (34, 34') including
a first choke coil (T1) having a pair of input nodes (e) adapted to be coupled to the incoming telephone line, and a pair of output nodes (f) coupled respectively to said first input nodes (a) of said first filter inductor (L1), thereby permitting coupling of said first input nodes (a) of said first filter inductor (L1) to the incoming telephone line, and
a second choke coil (T2) having a pair of input nodes (g) coupled respectively to said second output nodes (d) of said second filter inductor (L2), and a pair of output nodes (h) adapted to be coupled to a telephony instrument.

2. The signal splitter as claimed in Claim 1,
**characterized in that** at least one of said first and second filter inductors (L1, L2), and said first and second choke coils (T1, T2) includes a common core, and two mutually inductive windings (L1-1, L1-2, L2-1, L2-2, T1-1, T1-2, T2-1, T2-2) wound on said common core.

3. The signal splitter as claimed in Claim 1, **characterized in that** said common mode choke circuit (34, 34') further includes a third choke coil (T3) having a pair of input nodes (i) adapted to be coupled to the incoming telephone line, and a pair of output nodes (j) adapted to be coupled to a networking interface unit.

4. The signal splitter as claimed in Claim 3, further **characterized in that** said third choke coil (T3) includes acommoncore, and two mutually inductive windings (T3-1, T3-2) wound on said common core.

5. The signal splitter as claimed in Claim 1, **characterized in that** said common mode choke circuit (34') further includes a fourth choke coil (T4) having a pair of input nodes (k) coupled respectively to said first output nodes (b) of said first filter inductor (L1), and a pair of output nodes (1) coupled respectively to said second input nodes (c) of said second filter inductor (L2) such that said second input nodes (c) of said second filter inductor (L2) are coupled to said first output nodes (b) of said first filter inductor (L1) via said fourth choke coil (T4).

6. The signal splitter as claimed in Claim 5, further **characterized in that** said fourth choke coil (T4) includes a common core, and two mutually inductive windings (T4-1, T4-2) wound on said common core.
